# EUROPÄISCHE PATENTSCHRIFT

(11) **EP 3 918 313 B1**
(45) Veröffentlichungstag und Bekanntmachung des Hinweises auf die Patenterteilung: **23.08.2023**
(21) Anmeldenummer: 19829426.6
(22) Anmeldetag: 10.12.2019
(51) Int. Cl.: G01N 22/00

(54) **MESSGERÄT ZUR BESTIMMUNG EINES DIELEKTRIZITÄTSWERTES**
MEASURING DEVICE FOR DETERMINING A DIELECTRIC CONSTANT
DISPOSITIF DE MESURE POUR DÉTERMINER UNE VALEUR DIÉLECTRIQUE

(30) Priorität: 29.01.2019 DE 102019102142
(43) Veröffentlichungstag der Anmeldung: 08.12.2021
(73) Patentinhaber: Endress+Hauser SE+Co. KG, 79689 Maulburg (DE)
(72) Erfinder: BLÖDT, Thomas, 79585 Steinen (DE)
(74) Vertreter: Koslowski, Christine Adelheid
(86) Internationale Anmeldenummer: PCT/EP2019/084414
(87) Internationale Veröffentlichungsnummer: WO 2020/156713

(56) Entgegenhaltungen:
- US-A1- 2003 036 674
- US-A1- 2003 117 150
- US-A1- 2006 097 916

## Beschreibung

Die Erfindung betrifft ein Messgerät zur Bestimmung des Dielektrizitätswertes eines Füllgutes sowie ein Verfahren zum Betrieb des Messgerätes.

In der Automatisierungstechnik, insbesondere in der Prozessautomatisierungstechnik, werden vielfach Feldgeräte eingesetzt, die zur Erfassung und/oder zur Beeinflussung von Prozessvariablen dienen. Zur Erfassung von Prozessvariablen werden Sensoren eingesetzt, die beispielsweise in Füllstandsmessgeräten, Grenzstandmessegräten, Durchflussmessgeräten, Druck- und Temperaturmessgeräten, pH-Messgeräten, Leitfähigkeitsmessgeräten, oder Dielektrizitätswert-Messgeräten zum Einsatz kommen. Sie erfassen die entsprechenden Prozessvariablen, wie Füllstand, Grenzstand, Durchfluss, Druck, Temperatur, pH-Wert, Redoxpotential, Leitfähigkeit, oder den Dielektrizitätswert. Dabei werden unter dem Begriff "Behälter" im Rahmen der Erfindung auch nicht-abgeschlossene Behältnisse, wie beispielsweise Becken, Seen oder fließende Gewässer verstanden. Eine Vielzahl dieser Feldgeräte wird von der Firma Endress + Hauser hergestellt und vertrieben.

Die Bestimmung des Dielektrizitätswertes (auch bekannt als "*Dielektrizitätskonstante*", "*Dielektrizitätszahl*" oder "*Relative Permittivität*") ist sowohl bei Feststoffen, als auch bei flüssigen Füllgütern, wie beispielsweise Treibstoffen, Abwässern oder Chemikalien von großem Interesse, da dieser Wert einen zuverlässigen Indikator für Verunreinigungen, den Feuchtegehalt oder die Stoffzusammensetzung darstellen kann. Zur Bestimmung des Dielektrizitätswertes kann nach dem Stand der Technik vor allem bei flüssigen Füllgütern auf das kapazitive Messprinzip zurückgegriffen werden. Dabei wird der Effekt genutzt, dass sich die Kapazität eines Kondensators proportional mit dem Dielektrizitätswert desjenigen Mediums, das sich zwischen den zwei Elektroden des Kondensators befindet, ändert.

Alternativ ist es auch möglich, den Dielektrizitätswert eines (flüssigen) Mediums in einem Behälter-Inneren quasi parasitär bei dessen Füllstandsmessung mitzubestimmen. Dies erfordert das Messprinzip des geführten Radars, bei dem Mikrowellen über einen elektrisch leitfähigen Wellenleiter in das Medium geführt werden. Beschrieben ist diese kombinierte Füllstands- und Dielektrizitäts-Messung in der Offenlegungsschrift DE 10 2015 117 205 A1.

In der US-Veröffentlichungsschrift 2003/117150 A1 wird ein Messgerät zur Bestimmung eines Dielektrizitätswert-Profils über die Höhe eines Behälters beschrieben, das ebenfalls auf Basis von Mikrowellen arbeitet. Hierzu umfasst das dort vorgestellte Messgerät reihenförmig untereinander im Behälter anordbare Sende-Elemente und auf gleicher Höhe eine jeweils korrespondierende Reihe an Empfangs-Elementen. Ein Antennen-Array, das mehrere Reihen und Spalten an Einzel-Strahlelementen umfasst, ist in der Veröffentlichung US 20060097916 A1 gezeigt. Dabei werden die einzelnen Strahlelemente phasentechnisch aufeinander abgestimmt.

Eine weitere Alternative zum kapazitiven oder Mikrowellen-basierten Dielektrizitätswert-Messung besteht in induktiver Messung. Dieses Messprinzip beruht darauf, dass die resultierende Impedanz einer Spule nicht nur von ihrer Windungszahl, dem Windungsmaterial und dem Material des Spulenkerns abhängt, sondern auch vom Füllgut, das jeweils an die Spule angrenzt und somit vom Magnetfeld der Spule durchdrungen wird. Dementsprechend kann der Dielektrizitätswert mittels Messung der komplexen Spulen-Impedanz bestimmt werden.

Auf Basis der oben genannten Messprinzipien ist gegebenenfalls eine sehr genaue Bestimmung des Dielektrizitätswertes möglich. Allerdings nimmt der Wertebereich, in dem der Dielektrizitätswert bestimmbar ist, in der Regel umso mehr ab, je genauer der Wert messbar ist. Der Erfindung liegt daher die Aufgabe zugrunde, ein Messgerät bereitzustellen, mit dem der Dielektrizitätswert über einen möglichst großen Wertebereich bestimmbar ist.

Die Erfindung löst diese Aufgabe durch ein Messgerät zur Messung eines Dielektrizitätswertes eines Füllgutes, das folgende Komponenten umfasst:
- Eine Signalerzeugungs-Einheit, die konzipiert ist, um
- eine Sende-Einheit derart mittels eines elektrischen Hochfrequenz-Signals anzusteuern, dass die Sende-Einheit ein Radar-Signal in Richtung des Füllgutes aussendet,
- eine Empfangs-Einheit, die so im Behälter anordbar ist, um das Radar-Signal nach Durchlauf durch das Füllgut als Empfangs-Signal zu empfangen, und
- eine Auswertungs-Einheit, die ausgelegt ist, um zumindest anhand des Empfangs-Signals
   ∘ eine Amplitude des Empfangs-Signals, eine Phasenverschiebung des Empfangs-Signals zum Hochfrequenz-Signal und/oder eine Signal-Laufzeit des Radar-Signals zwischen der Sende-Einheit und der Empfangs-Einheit zu ermitteln, und
   ∘ um anhand der ermittelten Signal-Laufzeit, der Phasenverschiebung und/oder der ermittelten Amplitude den Dielektrizitätswert zu bestimmen.

Zur Erhöhung des Messbereichs zeichnet sich das erfindungsgemäße Messgerät dadurch aus, dass die Sende-Einheit und die Empfangs-Einheit eine korrespondierende Anzahl von zumindest zwei untereinander angeordneten Zeilen umfassen, wobei pro Zeile zumindest zwei Strahlelemente angeordnet sind. Dabei ist in Bezug zur jeweils anderen Einheit, also der Sende- oder Empfangs-Einheit, vor den Strahlern eine das Radar-Signal transmittierende Schicht angebracht.

Unter dem Begriff "*Einheit*" wird im Rahmen der Erfindung prinzipiell jede elektronische Schaltung verstanden, die für ihren Einsatzzweck geeignet ausgelegt ist. Es kann sich also je nach Anforderung um eine Analogschaltung zur Erzeugung bzw. Verarbeitung entsprechender analoger Signale handeln. Es kann sich jedoch auch um eine (halbleiterbasierte) Digitalschaltung wie einem FPGA oder einen Speichermedium in Zusammenwirken mit einem Programm handeln. Dabei ist das Programm ausgelegt, die entsprechenden Verfahrensschritte durchzuführen bzw. die notwendigen Rechenoperationen der jeweiligen Einheit anzuwenden. In diesem Kontext können verschiedene elektronische Einheiten des Messgerätes im Sinne der Erfindung potentiell auch auf einen gemeinsamen physikalischen Speicher zurückgreifen bzw. mittels derselben physikalischen Digitalschaltung betrieben werden.

Im Kontext dieser Erfindung definiert sich der Begriff "*Radar*" als allgemein als Signal bzw. elektromagnetische Welle mit einer Frequenz zwischen 0.03 GHz und 300 GHz. Bezüglich des erfindungsgemäßen Messgerätes ist es jedoch von Vorteil, wenn die Signalerzeugungs-Einheit ausgelegt ist, das Hochfrequenz-Signal mit einer Frequenz oberhalb von 1 GHz zu erzeugen.

Unter der Funktion eines "*Strahlelementes*" wird im Rahmen der Erfindung zum einen die Wirkweise von Antennen im Allgemeinen verstanden, wonach das Radar-Signal im Nahfeld als auch im Fernfeld abgestrahlt wird. Unter Strahlelementen werden jedoch auch jegliche Elemente verstanden, die Radar-Signale lediglich im Nahfeld abstrahlen. Aufgrund der reziproken Eigenschaften des Sendens und Empfangens gilt diese Eigenschaft analog zur Abstrahlung ebenso für den Empfang des Radar-Signals.

Erfindungsgemäß wird der Effekt genutzt, dass zwischen den einzelnen Zeilen eine zu- bzw. abnehmende Phasenverzögerung eingestellt werden kann. Diese bewirkt einen Messbereich-erhöhenden Effekt, wie es analog hierzu in der Audiotechnik als "*Dynamik-Kompression*" bzw. in der Bildverarbeitung als "*Tone Mapping*" bekannt ist.

Erfindungsgemäß wird eine zunehmende Phasenverzögerung pro Zeile erreicht, indem den Strahlelementen jeder Zeile zumindest ein Verzögerungsglied derart vor- bzw. nachgeschaltet wird, so dass das durch die Strahlelemente empfangene Empfangs-Signal mit zunehmender Zeile um jeweils eine definiert zu- oder abnehmende Phase verzögert ist. Realisiert werden kann ein Verzögerungsglied beispielsweise, wie es in der Veröffentlichungsschrift DE102012106938 A1 beschrieben ist.

Im Rahmen der Erfindung ist es nicht vorgeschrieben, wie viele Strahlelemente pro Zeile angeordnet sind. Zu einer Vergrößerung der Apertur in seitlicher Richtung und somit zu einer Steigerung der Auflösung der Dielektrizitätswert-Messung sind pro Zeile zumindest zwei, insbesondere mehr als 5 Strahlelemente an der Sende-Einheit bzw. der Empfangs-Einheit angeordnet. Für die mehreren Strahlelemente pro Zeile bietet es sich an, wenn eine Leiterbahnstruktur an der Sende-Einheit bzw. der Empfangs-Einheit die Strahlelemente einer Zeile derart symmetrisch kontaktiert, dass das Hochfrequenz-Signal bzw. das Empfangs-Signal an jedem Strahlelement der jeweiligen Zeile phasengleich ist. Hierdurch wird verhindert, dass die Strahlelemente derselben Zeile unterschiedliche Phasenverzögerungen hervorrufen.

Neben der Anzahl an Strahlelementen ist es zudem nicht fest vorgegeben, wie viele Zeilen die Sende-Einheit oder die Empfangs-Einheit umfasst. Da auch mit steigender Anzahl an Zeilen die Apertur erhöht wird bzw. Auflösung der Dielektrizitätswert-Messung steigt, ist es jedoch von Vorteil, wenn die Sende-Einheit bzw. die Empfangs-Einheit mehr als mehr als 5 Zeilen mit jeweils zumindest einem Strahlelement umfassen/umfasst. Zur kompakten Auslegung der Sende-Einheit und der Empfangs-Einheit ist es allgemein von Vorteil, die Strahlelemente als Planar-Strahler, insbesondere als Patch-, Spiral-, Dipol- oder Fraktal-Antennen auszulegen.

Das anzuwendende Verfahren zur Bestimmung der Signallaufzeit des Radar-Signals (und somit zur Bestimmung des Realteils des Dielektrizitätswertes) ist erfindungsgemäß nicht fest vorgegeben. So kann als Messprinzip beispielsweise das Pulslaufzeit-Verfahren, das FMCW-Verfahren (Akronym für "Frequency Modulated Continuos Wave") oder ein Phasenauswertungs-Verfahren, wie bspw. ein interferometrisches Verfahren, angewendet werden. Die Messprinzipien des FMCW- und Pulsradar- basierten Laufzeit-Messverfahren werden beispielsweise in "Radar Level Measurement"; Peter Devine, 2000 beschrieben.

Wenn das Messgerät die Signallaufzeit mittels des FMCW-Verfahrens bestimmen soll, so ist die Signalerzeugungs-Einheit auszulegen, um das Hochfrequenz-Signal derart mit einer variierenden Frequenz zu erzeugen, so dass die Auswertungs-Einheit die Signal-Laufzeit anhand einer Differenzfrequenz zwischen dem ausgesendeten Radar-Signal und dem empfangenen Radar-Signal bestimmen kann. Bei Implementierung des Pulslaufzeit-Verfahrens ist die Signalerzeugungs-Einheit auszulegen, um das Hochfrequenz-Signal derart pulsförmig zu erzeugen, so dass die Auswertungs-Einheit die Signal-Laufzeit anhand einer Pulslaufzeit zwischen der Sende-Einheit und der Empfangs-Einheit bestimmen kann. Unabhängig vom Messprinzip zur Bestimmung der Laufzeit ist es von Vorteil, wenn die Signalerzeugungs-Einheit ausgelegt ist, das Hochfrequenz-Signal mit einer Frequenz von mindestens 1 GHz zu erzeugen. Je höher die Frequenz eingestellt wird, desto kompakter kann das Messgerät insgesamt ausgelegt werden. Außerdem kann bei höheren Frequenzen auch der Dielektrizitätswert von Füllgütern mit höherer elektrischer Leitfähigkeit, wie beispielsweise Salz-haltigen Flüssigkeiten, bestimmt werden, ohne dass ein Kurzschluss zwischen der Sende-Einheit und der Empfangs-Einheit verursacht wird.

Analog zum erfindungsgemäßen Messgerät wird die Aufgabe, die der Erfindung zugrunde liegt, zudem durch ein entsprechendes Messverfahren gelöst, mittels dem ein Dielektrizitätswert eines in einem Behälter befindlichen Füllgutes bestimmt werden kann. Korrespondierend zum Messgerät umfasst das Messverfahren folgende Verfahrensschritte:
- Aussenden eines Radar-Signals in Richtung des Füllgutes,
- Empfang des Radar-Signals nach Durchlauf durch das Füllgut,
- Bestimmung einer Amplitude des empfangenen Radar-Signals, einer Phasenverschiebung zwischen Aussenden und Empfang des Radar-Signals und/oder einer Signal-Laufzeit zwischen Aussenden und Empfang des Radar-Signals, und
- Ermittlung des Dielektrizitätswertes anhand der Amplitude, der Phasenverschiebung und/oder der Signallaufzeit.

Das Verfahren zeichnet sich analog zum erfindungsgemäßen Messgerät dadurch aus, dass das Radar-Signal über Strahlelemente, die in zumindest zwei untereinander angeordneten Zeilen angeordnet sind, derart ausgesendet und/oder empfangen wird, so dass das von dem zumindest einen Strahlelement pro Zeile empfangene Empfangs-Signal mit zunehmender Zeile um jeweils eine definiert zu- oder abnehmende Phase verzögert ist.

Anhand der nachfolgenden Figuren wird die Erfindung näher erläutert. Es zeigt:
Fig. 1: eine schematische Anordnung eines erfindungsgemäßen Messgerätes an einem Behälter,
Fig. 2: einen prinzipiellen Aufbau des erfindungsgemäßen Messgerätes,
Fig. 3: eine Frontalansicht der Sende-Einheit bzw. der Empfangs-Einheit, und
Fig. 4: eine mögliche symmetrische Ansteuerung der Strahlelemente in einer Zeile der Sende-Einheit bzw. der Empfangs-Einheit.

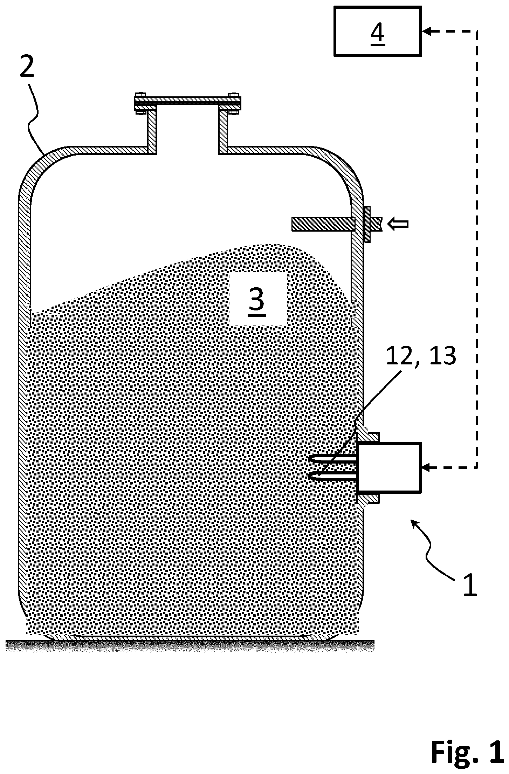

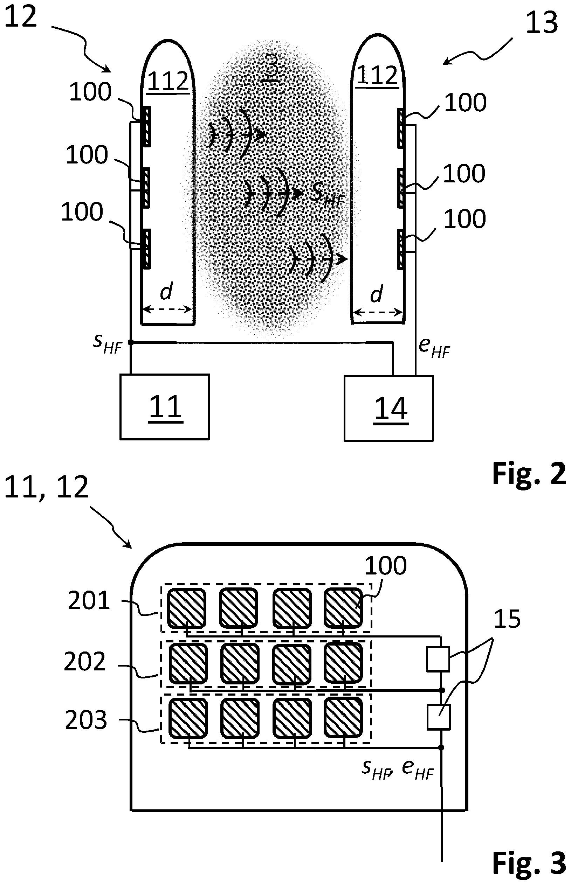

Zum allgemeinen Verständnis des erfindungsgemäßen Messgerätes 1 ist in Fig. 1 eine schematische Anordnung des Messgerätes 1 an einem geschlossenen Behälter 2 gezeigt. Es versteht sich dabei von selbst, dass die Erfindung auch an offenen Behältnissen wir Rohren eingesetzt werden kann. In dem in Fig. 2 gezeigten Behälter 2 befindet sich ein Füllgut 3, dessen Dielektrizitätswert DK zu bestimmen ist. Hierzu ist das Messgerät 1 seitlich an einem Anschluss des Behälters 2, wie bspw. einem Flanschanschluss angeordnet. Dabei ist das Messgerät 1 so ausgelegt, dass eine Sende-Einheit 12 und eine Empfangs-Einheit 13 des Messgerätes 1 über die Innenwand des Behälters 2 hinaus in das Behälter-Innere abstehen und dadurch in Kontakt mit dem Füllgut 3 stehen. Diese Einheiten 12, 13 sind in der gezeigten Ausführungsform parallel, also ohne Verkippung zueinander ausgerichtet. Dabei befindet sich das Füllgut 3 zumindest teilweise zwischen diesen zwei Einheiten 12, 13 befindet.

Bei dem Füllgut 3 kann es sich um Flüssigkeiten wie Getränke, Lacke, Zement oder Treibstoffe wie Flüssiggase oder Mineralöle handeln. Denkbar ist jedoch auch die Verwendung des Messgerätes 1 bei Schüttgut-förmigen Füllgütern 3, wie bspw. Getreide oder Mehl. Je nach Art des Füllgutes 3 weist es also einen sehr unterschiedlichen Dielektrizitätswert DK auf. Dementsprechend muss das Messgerät 1 ausgelegt sein, den Dielektrizitätswert DK in einem sehr weiten Messbereich bestimmen zu können.

Das Messgerät 1 kann mit einer übergeordneten Einheit 4, zum Beispiel einem Prozessleitsystem, verbunden sein. Als Schnittstelle kann etwa "PROFIBUS", "HART" oder "Wireless HART" implementiert sein. Hierüber kann der Dielektrizitätswert DK übermittelt werden. Es können aber auch anderweitige Informationen über den allgemeinen Betriebszustand des Messgerätes 1 kommuniziert werden.

Der prinzipielle schaltungstechnische Aufbau des Messgerätes 1 wird anhand von Fig. 2 näher veranschaulicht: Wie zu erkennen ist, dient die Sende-Einheit 12 zum Aussenden eines Radar-Signal S_{HF}. Die parallel gegenüber angeordnete Empfangs-Einheit 13 dient zum Empfang des Radar-Signals S_{HF}, nachdem es das Füllgut 3 zwischen den zwei Einheiten 12, 13 durchdrungen hat.

Zur Erzeugung des Radar-Signals S_{HF} steuert eine Signalerzeugungs-Einheit 11 die Sende-Einheit 12 mittels eines entsprechenden Hochfrequenz-Signals S_{HF} an. Dabei wird die Wellenlänge des Radar-Signals S_{HF} durch die Frequenz des Hochfrequenz-Signals S_{HF} festgelegt. Da der Dielektrizitätswert DK des Füllgutes 3 erfindungsgemäß durch Messung der Amplitude des empfangenen Radar-Signals S_{HF} bzw. durch Messung der Signal-Laufzeit zwischen der Sende-Einheit 12 und der Empfangs-Einheit 13 ermittelt wird, ist die Empfangs-Einheit 13 an eine hierzu ausgelegte Auswertungs-Einheit 14 angeschlossen. Hierdurch empfängt die Auswertungs-Einheit 14 das an der Empfangs-Einheit 13 eintreffende Radar-Signal S_{HF} entsprechend als elektrisches Empfangssignal e_{HF}. Da sich die Amplitude proportional zum Imaginärteil des Dielektrizitätswertes DK verhält, kann anhand der Amplitude des empfangenen Radar-Signals S_{HF} der Imaginärteil bestimmt werden. Analog gilt dies für die Signal-Laufzeit bzw. die Phasenverschiebung und den Realteil des Dielektrizitätswertes DK.

Da es erfindungsgemäß nicht fest vorgeschrieben ist, welches Messprinzip zur Bestimmung der Signal-Laufzeit des Radar-Signals S_{HF} eingesetzt wird, sind die Auswertungs-Einheit 14 und der Signalerzeugungs-Einheit 11 in Abhängigkeit des implementierten Messprinzips auszulegen. Hierbei kann auf jeweils bekannte Schaltungskomponenten zurückgegriffen werden: Im Fall von FMCW kann die Signalerzeugungs-Einheit 11 auf Basis einer PLL ("*Phase Locked Loop*") aufbaut sein; Die Auswertungs-Einheit 14 kann mittels eines Mischers das gesendete Hochfrequenz-Signal s_{HF} mit dem Empfangs-Signal e_{HF} mischen, um anhand der Differenzfrequenz des gemischten Signals die Laufzeit zu ermitteln. Dies kann beispielsweise per FFT ("*Fast Fourier Transformation*") des gemischten Signals e_{HF} mittels eines entsprechenden Rechenblocks erfolgen.

Bei Implementierung des Puls-Laufzeit-Verfahrens kann die Signalerzeugungs-Einheit 11 zur pulsförmigen Erzeugung des Hochfrequenz-Signals s_{HF} einen entsprechend zyklisch angesteuerten Oszillator, beispielsweise einen spannungsgesteuerten Oszillator oder lediglich einen Quarzoszillator, umfassen. Die Auswertungs-Einheit 14 kann das Empfangs-Signal e_{HF} beim Puls-Laufzeit-Verfahren durch Unterabtastung verarbeiten. Somit kann die Auswertungs-Einheit 14 die Signal-Laufzeit des korrespondierenden Signalmaximums anhand des abgetasteten und somit zeitgedehnten Signals ermitteln. Es versteht sich im Zusammenhang der Laufzeit-Bestimmung von selbst, dass alternativ zum Puls-Laufzeit-Verfahren oder dem FMCW-Verfahren jegliche andere geeignete Methode zur Bestimmung der Signal-Laufzeit angewendet werden kann. Eine weitere mögliche Methode zur Laufzeit-Bestimmung ist beispielsweise in der Veröffentlichungsschrift WO 2017045788 A1 beschrieben.

Bezüglich der Struktur können die Sende-Einheit 12 und die Empfangs-Einheit 13 prinzipiell analog aufgebaut sein: Kern der Erfindung ist hierbei, dass die Sende-Einheit 12 und die Empfangs-Einheit 13 nicht nur ein Strahlelement 100 aufweisen, sondern zumindest zwei untereinander angeordnete Zeilen mit jeweils zumindest zwei Strahlelementen 100.

Bei der in Fig. 2 gezeigten Ausführungsvariante weisen beide Einheiten 12, 13 drei Zeilen 201, 202, 203 auf, in denen jeweils Strahlelemente 100 angeordnet sind (vgl. auch Fig. 3). Vor den Strahlelementen 100 (in Bezug zur jeweils anderen Einheit 12, 13) ist zu deren Schutz gegen das Füllgut 3 jeweils eine Schicht 112 angebracht, die für das Radar-Signal S_{HF} transmittierend ist. Geeignete Schicht-Materialien sind beispielsweise Al₂O₃, PE, PP, PTFE oder metallische Gläser.

Im Sinne der Erfindung sind die Strahlelemente 100 der einzelnen Zeilen 201, 202, 203 so durch die Sende-Einheit 12 bzw. die Empfangs-Einheit 13 anzusteuern, dass das von den Strahlelementen 100 empfangene Empfangs-Signal e_{HF} mit zunehmender Zeile 201, 202, 203 um jeweils eine definiert zu- oder abnehmende Phase verzögert wird. Dies kann prinzipiell auf zwei Arten implementiert werden: Zum einen kann das Radar-Signal S_{HF} bereits an der Sende-Einheit 12 mit pro Zeile zunehmender Phasenverzögerung ausgesendet werden. Alternativ oder zusätzlich hierzu kann die pro Zeile zunehmende Phasenverzögerung auch an der Empfangs-Einheit 13 herbeigeführt werden. Durch die pro Zeile 201, 202, 203 zunehmende Phasenverzögerung erhöht sich der Messbereich, über den der Dielektrizitätswert DK bestimmt werden kann.

Die in Fig. 3 gezeigte, serielle Anordnung der zwei Verzögerungselemente 15 bewirkt in Bezug auf die drei Zeilen 201, 202, 203, dass die Antennen 100 untersten Zeile 203 nicht verzögert werden, während die oberste Zeile 201 im Vergleich zur zweiten Zeile 202 die doppelte Phasenverzögerung erfährt (vorausgesetzt, beide Verzögerungsglieder 15 erzeugen dieselbe Phasenverzögerung). Pro Zeile 201, 202, 203 nimmt also die Phasenverzögerung um den Wert jeweils eines Verzögerungsgliedes 15 ab. Zwecks individueller Anpassung der Phasenverzögerung können die Phasenverzögerungsglieder 15 natürlich auch so konzipiert werden, dass sie nicht dieselbe Phasenverzögerung hervorrufen.

Aufgrund der hohen Frequenz des Radar-Signals im GHz-Bereich ist es zwecks kompakter Auslegung vorzuziehen, wenn die Strahlelemente 100 als Planar-Strahler ausgelegt sind. Beispielsweise können die Strahlelemente 100 als Patch-, Spiral- oder Fraktal-Antennen ausgelegt werden, die auf einem Leiterplattensubstrat angeordnet sind. Somit können die Strahlelemente 100 analog zu Leiterbahnen bspw. als Kupferlage aufgebracht bzw. strukturiert werden. Bei einer Frequenz zwischen 2 GHz und 30 GHz ist die Kantenlänge der Patch-Antennen zwischen 0,2 mm und 50 mm zu dimensionieren. Sofern kein Fernfeld ausgebildet werden soll, ist die Kantenlänge deutlich kleiner als ein Viertel der Wellenlänge des Radar-Signals S_{HF} zu bemaßen. Eine Abstrahlung lediglich im Nahfeld weist den Vorteil auf, dass das Radar-Signal S_{HF} mit höherer Sende-Leistung ausgestrahlt werden kann, ohne gegen behördliche Funk-Zulassungsvorschriften zu verstoßen.

Sofern die Strahlelemente 100 der Sende-Einheit 12 bzw. der Empfangs-Einheit 13 auf einem Leiterplattensubstrat angebracht sind, können die Strahlelemente 100 über entsprechende Leiterbahnen, die insbesondere als Mikrostreifenleitungen ausgelegt sein können, mit der Signalerzeugungs-Einheit 11 bzw. der Auswertungs-Einheit 14 kontaktiert werden.

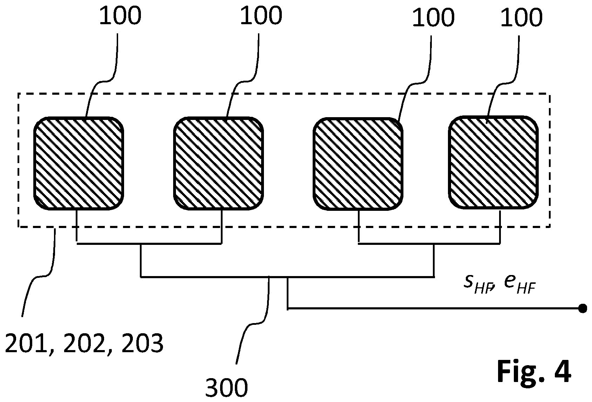

Damit die Strahlelemente 100 der jeweiligen Zeile 201, 202, 203 nicht untereinander eine abweichende Phase bezüglich des Radar-Signals S_{HF} hervorrufen, ist die Weglänge jeder Leiterbahn zum entsprechenden Strahlelement 100 der jeweiligen Zeile 201, 202, 203 gleich lang auszulegen. Eine mögliche Variante, dies bei einer geraden Anzahl an Strahlelementen 100 pro Zeile 201, 202, 203 zu realisieren, ist in Fig. 4 gezeigt. Dort sind die vier Strahlelemente 100 einer Zeile 201, 202, 203 über eine baumförmige Leiterbahnstruktur 300 auf ein Potential zusammengefasst. Dabei umfasst die Leiterbahnstruktur 300 zwei Ebenen der Verästelung, wobei auf jeder Ebene jeweils zwei gleich lange Leiterbahnäste zu den Strahlelementen 100 abzweigen. Hierdurch sind die Strahlelemente 100 dieser Zeile 201, 202, 203 symmetrisch kontaktiert, so dass das Hochfrequenz-Signal s_{HF} bzw. das Empfangs-Signal e_{HF} an jedem Strahlelement 100 der jeweiligen Zeile 201, 202, 203 phasengleich ist.

### Bezugszeichenliste

- 1: Messgerät
- 2: Behälter
- 3: Füllgut
- 4: Übergeordnete Einheit
- 11: Signalerzeugungs-Einheit
- 12: Sende-Einheit
- 13: Empfangs-Einheit
- 14: Auswertungs-Einheit
- 15: Verzögerungsglied
- 100: Strahlelemente
- 112: Transmittierende Schicht
- 201 -203: Zeilen
- 300: Leiterbahnstruktur
- DK: Dielektrizitätswert
- d: Dicke der transmittierenden Schicht
- e_{HF}: Empfangs-Signal
- S_{HF}: Radar-Signal
- s_{HF}: Hochfrequenz-Signal

## Patentansprüche

1. Messgerät zur Messung eines Dielektrizitätswertes (DK) eines Füllgutes (3), umfassend:
- Eine Signalerzeugungs-Einheit (11), die konzipiert ist, um
- eine Sende-Einheit (12) derart mittels eines elektrischen Hochfrequenz-Signals (s_{HF}) anzusteuern, dass die Sende-Einheit (12) ein Radar-Signal (S_{HF}) in Richtung des Füllgutes (3) aussendet,
- eine Empfangs-Einheit (13), die so im Behälter (2) anordbar ist, um das Radar-Signal (S_{HF}) nach Durchlauf durch das Füllgut (3) als Empfangs-Signal (e_{HF}) zu empfangen, und
- eine Auswertungs-Einheit (14), die ausgelegt ist, um zumindest anhand des Empfangs-Signals (e_{HF})
∘ eine Amplitude des Empfangs-Signals (e_{HF}), eine Phasenverschiebung des Empfangs-Signals (e_{HF}) zum Hochfrequenz-Signal (s_{HF}) und/oder eine Signal-Laufzeit des Radar-Signals (S_{HF}) zwischen der Sende-Einheit (12) und der Empfangs-Einheit (13) zu ermitteln, und
∘ um anhand der ermittelten Signal-Laufzeit, der Phasenverschiebung und/oder der ermittelten Amplitude den Dielektrizitätswert (DK) zu bestimmen,
wobei in Bezug zur jeweils anderen Einheit (12, 13) vor den Strahlern (100) eine für das Radar-Signal (S_{HF}) transmittierende Schicht (112) angebracht ist,
**dadurch gekennzeichnet, dass**
die Sende-Einheit (12) und die Empfangs-Einheit (13) eine korrespondierende Anzahl von zumindest zwei untereinander angeordneten Zeilen (201, 202, 203) umfassen, wobei pro Zeile (201, 202, 203) zumindest zwei Strahlelemente (100) angeordnet sind, und
wobei den Strahlelementen (100) jeder Zeile (201, 202, 203) zumindest ein Verzögerungsglied (15) derart vor- bzw. nachgeschaltet ist, dass das durch die Strahlelemente (100) empfangene Empfangs-Signal (e_{HF}) mit zunehmender Zeile (201, 202, 203) um jeweils eine definiert zu- oder abnehmende Phase verzögert ist.

2. Messgerät nach Anspruch 1, wobei pro Zeile (201, 202, 203) mehr als 5 Strahlelemente (100) angeordnet sind.

3. Messgerät nach Anspruch 2, wobei eine Leiterbahnstruktur (300) an der Sende-Einheit (12) bzw. der Empfangs-Einheit (13) die Strahlelemente (100) einer Zeile (201, 202, 203) derart symmetrisch kontaktiert, dass das Hochfrequenz-Signal (s_{HF}) bzw. das Empfangs-Signal (e_{HF}) an jedem Strahlelement (100) der jeweiligen Zeile (201, 202, 203) phasengleich ist.

4. Messgerät nach einem der vorhergehenden Ansprüche, wobei die Sende-Einheit (12) bzw. die Empfangs-Einheit (13) mehr als zwei, insbesondere mehr als 5 Zeilen (201, 202, 203) mit jeweils zumindest einem Strahlelement (100) umfassen/umfasst.

5. Messgerät nach einem der vorhergehenden Ansprüche, wobei die transmittierende Schicht (112) aus einem Material gefertigt ist, dass eine relative Dielektrizitätszahl zwischen 2 und 40 aufweist, und/oder wobei das Material, aus dem transmittierende Schicht (112) gefertigt ist, eine magnetische Permeabilität zwischen 0,5 und 10 aufweist.

6. Messgerät nach einem der vorhergehenden Ansprüche, wobei die Signalerzeugungs-Einheit (12) ausgelegt ist, das Hochfrequenz-Signal (s_{HF}) derart mit einer variierenden Frequenz (f) zu erzeugen, dass die Signal-Laufzeit mittels der Auswertungs-Einheit (14) anhand einer Frequenzdifferenz zwischen dem ausgesendeten Radar-Signal (S_{HF}) und dem empfangenen Radar-Signal (S_{HF}) bestimmbar ist.

7. Messgerät nach einem der vorhergehenden Ansprüche, wobei die Signalerzeugungs-Einheit (12) ausgelegt ist, das Hochfrequenz-Signal (s_{HF}) derart pulsförmig auszusenden, dass die Signal-Laufzeit mittels der Auswertungs-Einheit (14) anhand einer Pulslaufzeit zwischen der Sende-Einheit (12) der Empfangs-Einheit (13) bestimmbar ist.

8. Messgerät nach einem der vorhergehenden Ansprüche, wobei die Signalerzeugungs-Einheit (11) ausgelegt ist, das Hochfrequenz-Signal (s_{HF}) mit einer Frequenz von mindestens 1 GHz zu erzeugen.

9. Messgerät nach einem der vorhergehenden Ansprüche, wobei die Strahlelemente (100) als Planar-Strahler, insbesondere als Patch-, Spiral- oder Fraktal-Antennen ausgelegt sind.

10. Verfahren zur Messung eines Dielektrizitätswertes (DK) eines in einem Behälter (2) befindlichen Füllgutes (3) mittels des Messgerätes (1) nach einer der vorhergehenden Ansprüche, folgende Verfahrensschritte umfassend:
- Aussenden eines Radar-Signals (S_{HF}) in Richtung des Füllgutes (3),
- Empfang des Radar-Signals (S_{HF}) nach Durchlauf durch das Füllgut (3),
- Bestimmung einer Amplitude des empfangenen Radar-Signals (S_{HF}), einer Phasenverschiebung zwischen Aussenden und Empfang des Radar-Signals (S_{HF}) und/oder einer Signal-Laufzeit zwischen Aussenden und Empfang des Radar-Signals (S_{HF}), und
- Ermittlung des Dielektrizitätswertes (DK) anhand der Amplitude, der Phasenverschiebung und/oder der Signallaufzeit,
**dadurch gekennzeichnet, dass**
das Radar-Signal (S_{HF}) über Strahlelemente (100), die in zumindest zwei untereinander angeordneten Zeilen (201, 202, 203) angeordnet sind, derart ausgesendet und/oder empfangen wird, so dass das von dem zumindest einen Strahlelement (100) pro Zeile (201, 202, 203) empfangene Empfangs-Signal (e_{HF}) mit zunehmender Zeile (201,202, 203) um jeweils eine definiert zu- oder abnehmende Phase verzögert ist.

## Claims

1. A measuring device for measuring a dielectric constant (DK) of contents (3), comprising:
- a signal generating unit (11) which is designed
- to control a transmitting unit (12) by means of a high-frequency electrical signal (S_{HF}) such that the transmitting unit (12) emits a radar signal (S_{HF}) toward the contents (3),
- a receiving unit (13) which can be arranged in the container (2) so as to receive the radar signal (S_{HF}) after it has passed through the contents (3) as a received signal (e_{HF}), and
- an evaluation unit (14) which is configured, at least by reference to the received signal (e_{HF}),
∘ to ascertain an amplitude of the received signal (e_{HF}), a phase shift of the received signals (e_{HF}) to the high-frequency signal (S_{HF}) and/or a signal propagation time of the radar signal (S_{HF}) between the transmitting unit (12) and the receiving unit (13), and
∘ to determine dielectric constant (DK) by reference to the ascertained signal propagation time, the phase shift and/or the ascertained amplitude,
wherein a transmitting layer (112) for the radar signal (SHF) is attached upstream of the radiators (100) with respect to the other unit (12, 13) in each case,
wherein
the transmitting unit (12) and the receiving unit (13) comprise a corresponding number of at least two lines (201, 202, 203) arranged one above the other, wherein at least two radiation elements (100) are arranged per line (201, 202, 203),
wherein at least one delay element (15) is arranged upstream or downstream of the radiation elements (100) in each line (201, 202, 203) such that the received signal (e_{HF}) received by the radiation elements (100) is delayed by in each case a defined increasing or decreasing phase with increasing lines (201, 202, 203).

2. The measuring device as claimed in claim 1,
wherein more than 5 radiation elements (100) are arranged per line (201, 202, 203).

3. The measuring device as claimed in claim 2,
wherein a conductor path structure (300) on the transmitting unit (12) or the receiving unit (13) symmetrically contacts the radiation elements (100) of a line (201, 202, 203) such that the high-frequency signal (S_{HF}) or the received signal (e_{HF}) is in the same phase on each radiation element (100) of the respective line (201, 202, 203).

4. The measuring device as claimed in one of the preceding claims, wherein the transmitting unit (12) and/or the receiving unit (13) comprise/comprises more than two, in particular more than 5 lines (201, 202, 203) with in each case at least one radiation element (100).

5. The measuring device as claimed in one of the preceding claims, wherein the transmitting layer (112) is made of a material that has a relative dielectric constant between 2 and 40, and/or wherein the material from which the transmitting layer (112) is made has a magnetic permeability between 0.5 and 10.

6. The measuring device as claimed in one of the preceding claims, wherein the signal generating unit (12) is configured to generate the high-frequency signal (S_{HF}) with a varying frequency (f) such that the signal propagation time can be determined by means of the evaluation unit (14) by reference to a frequency difference between the emitted radar signal (S_{HF}) and the received radar signal (S_{HF}).

7. The measuring device as claimed in one of the preceding claims, wherein the signal generating unit (12) is configured to emit the high-frequency signal (S_{HF}) in pulse form such that the signal propagation time can be determined by means of the evaluation unit (14) by reference to a pulse propagation time between the transmitting unit (12) and the receiving unit (13).

8. The measuring device as claimed in one of the preceding claims, wherein the signal generating unit (11) is configured to generate the high-frequency signal (S_{HF}) with a frequency of at least 1 GHz.

9. The measuring device as claimed in one of the preceding claims, wherein the radiation elements (100) are configured as planar radiators, in particular as patch antennas, spiral antennas or fractal antennas.

10. A method for measuring a dielectric constant (DK) of contents (3) of a container (2) by means of the measuring device (1) according to one of the preceding claims, comprising the following method steps:
- emitting a radar signal (S_{HF}) toward the contents (3),
- receiving the radar signal (S_{HF}) after it has passed through the contents (3),
- determining an amplitude of the received radar signal (S_{HF}), a phase shift between emitting and receiving the radar signal (S_{HF}) and/or a signal propagation time between emitting and receiving the radar signal (S_{HF}), and
- ascertaining the dielectric constant (DK) by reference to the amplitude, the phase shift and/or the signal propagation time,
wherein
the radar signal (S_{HF}) is emitted and/or received via radiation elements (100) which are arranged in at least two lines (201,202, 203) arranged one above the other such that the received signal (e_{HF}) received from the at least one radiation element (100) per line (201, 202, 203) is delayed by in each case a defined increasing or decreasing phase with increasing lines (201, 202, 203).

## Revendications

1. Appareil de mesure destiné à mesurer une valeur diélectrique (DK) d'un produit (3), lequel appareil comprend :
- une unité de génération de signaux (11), laquelle est conçue pour commander
- une unité d'émission (12) au moyen d'un signal électrique à haute fréquence (s_{HF}) de telle sorte que l'unité d'émission (12) émette un signal radar (S_{HF}) en direction du produit (3),
- une unité de réception (13), laquelle peut être disposée dans le réservoir (2) de manière à recevoir le signal radar (S_{HF}) en tant que signal de réception (e_{HF}) après son passage à travers le produit (3), et
- une unité d'exploitation (14), laquelle est conçue pour déterminer, au moins à l'aide du signal de réception (e_{HF}),
o une amplitude du signal de réception (e_{HF}), un déphasage du signal de réception (e_{HF}) par rapport au signal haute fréquence (s_{HF}) et/ou un temps de propagation du signal radar (S_{HF}) entre l'unité d'émission (12) et l'unité de réception (13), et pour déterminer
o la valeur diélectrique (DK) à l'aide du temps de propagation du signal déterminé, du déphasage et/ou de l'amplitude déterminée,
une couche (112) de transmission pour le signal radar (S_{HF}) étant appliquée devant les éléments de rayonnement (100) par rapport à l'autre unité respective (12, 13),
**caractérisé en ce que**
l'unité d'émission (12) et l'unité de réception (13) comprennent un nombre correspondant d'au moins deux lignes (201, 202, 203) disposées l'une au-dessous de l'autre, au moins deux éléments de rayonnement (100) étant disposés par ligne (201, 202, 203), et
au moins un élément de temporisation (15) étant monté en amont ou en aval des éléments de rayonnement (100) de chaque ligne (201 , 202, 203), de telle sorte que le signal de réception (e_{HF}) reçu par les éléments de rayonnement (100) est retardé respectivement d'une phase définie croissante ou décroissante avec une ligne (201, 202, 203) croissante.

2. Appareil de mesure selon la revendication 1, pour lequel plus de 5 éléments de rayonnement (100) sont disposés par ligne (201, 202, 203).

3. Appareil de mesure selon la revendication 2, pour lequel une structure de pistes conductrices (300) sur l'unité d'émission (12) ou l'unité de réception (13) met en contact les éléments de rayonnement (100) d'une ligne (201, 202, 203) de manière symétrique de telle sorte que le signal haute fréquence (s_{HF}) ou le signal de réception (e_{HF}) est en phase sur chaque élément de rayonnement (100) de la ligne respective (201, 202, 203).

4. Appareil de mesure selon l'une des revendications précédentes, pour lequel l'unité d'émission (12) et l'unité de réception (13) comprennent respectivement plus de deux, notamment plus de 5 lignes (201, 202, 15 203) avec chacune au moins un élément de rayonnement (100).

5. Appareil de mesure selon l'une des revendications précédentes,
pour lequel la couche de transmission (112) est fabriquée dans un matériau qui présente une constante diélectrique relative comprise entre 2 et 40, et/ou pour lequel le matériau dans lequel est fabriquée la couche de transmission (112) présente une perméabilité magnétique comprise entre 0,5 et 10.

6. Appareil de mesure selon l'une des revendications précédentes, pour lequel l'unité de génération de signaux (12) est conçue pour générer le signal haute fréquence (s_{HF}) avec une fréquence (f) variable de telle sorte que le temps de propagation du signal peut être déterminé au moyen de l'unité d'exploitation (14) à l'aide d'une différence de fréquence entre le signal radar (s_{HF}) émis et le signal radar (s_{HF}) reçu.

7. Appareil de mesure selon l'une des revendications précédentes, pour lequel l'unité de génération de signaux (12) est conçue pour émettre le signal haute fréquence (s_{HF}) sous forme d'impulsions, de telle sorte que le temps de propagation du signal peut être déterminé au moyen de l'unité d'exploitation (14) à l'aide d'un temps de propagation des impulsions entre l'unité d'émission (12) et l'unité de réception (13).

8. Appareil de mesure selon l'une des revendications précédentes, pour lequel l'unité de génération de signaux (11) est conçue pour générer le signal haute fréquence (s_{HF}) à une fréquence d'au moins 1 GHz.

9. Appareil de mesure selon l'une des revendications précédentes, pour lequel les éléments de rayonnement (100) sont conçus comme des éléments de rayonnement Planar, notamment comme des antennes patch, spirales ou fractales.

10. Procédé destiné à la mesure d'une valeur diélectrique (DK) d'un produit (3) se trouvant dans un réservoir (2) au moyen de l'appareil de mesure (1) selon l'une des revendications précédentes, lequel procédé comprend les étapes suivantes :
- Émission d'un signal radar (S_{HF}) en direction du produit (3),
- Réception du signal radar (S_{HF}) après son passage à travers le produit (3),
- Détermination d'une amplitude du signal radar reçu (S_{HF}), d'un déphasage entre l'émission et la réception du signal radar (S_{HF}) et/ou d'un temps de propagation du signal entre l'émission et la réception du signal radar (S_{HF}), et
- Détermination de la valeur diélectrique (DK) à l'aide de l'amplitude, du déphasage et/ou du temps de propagation du signal,
**caractérisé en ce que**
le signal radar (S_{HF}) est émis par l'intermédiaire d'éléments de rayonnement (100), lesquels sont disposés en au moins deux lignes (201, 202, 203) disposées l'une en dessous de l'autre, de telle sorte que le signal de réception (e_{HF}) reçu par l'au moins un élément de rayonnement (100) par ligne (201, 202, 203) est retardé d'une phase croissante ou décroissante définie avec une ligne (201, 202, 203) croissante.
